Europäisches Patentamt

European Patent Office

Office européen des brevets

(11) Veröffentlichungsnummer: **0 338 489**
**A2**

(12) **EUROPÄISCHE PATENTANMELDUNG**

(21) Anmeldenummer: **89106887.6**

(22) Anmeldetag: **18.04.89**

(51) Int. Cl.⁴: **G01R 19/165**

(30) Priorität: **20.04.88 DE 3813269**

(43) Veröffentlichungstag der Anmeldung:
**25.10.89 Patentblatt 89/43**

(84) Benannte Vertragsstaaten:
**AT BE CH DE ES FR GB IT LI NL SE**

(71) Anmelder: **Siemens Aktiengesellschaft**
**Wittelsbacherplatz 2**
**D-8000 München 2(DE)**

(72) Erfinder: **Busch, Peter, Dipl.-Ing.(FH)**
**Thommstrasse 24b**
**D-8900 Augsburg(DE)**
Erfinder: **Sterzik, Willi Dipl.-Ing.(FH)**
**Karlsbader Strasse 28**
**D-8900 Augsburg(DE)**

(54) **Netzüberwachungsschaltung.**

(57) Die Netzüberwachungsschaltung weist für Netzunterspannung- und Netzausfallserkennung je einen entsprechend vorgegeben belasteten Kondensator (K1 bzw. K2) auf, die jeweils an die gleichgerichtete Spannung wenigstens eines Teils der Netzspannung angeschlossen sind. Jeder der Kondensatoren (K1 bzw. K2) ist mit einem eigenen Spannungsvergleicher (SV1 bzw. SV2) verbunden, der die Kondensatorspannung mit einer der jeweiligen Kondensatorbelastung angepaßten Referenzspannung ($U_{ref}1$ bzw. $U_{ref}2$) vergleicht. Bei Netzunterspannung bzw. Netzausfall entlädt sich entweder der eine oder andere Kondensator (K1 bzw. K2) gemäß seiner Belastung gegebenenfalls bis unter die zu ihm gehörige Referenzspannung ($U_{ref}1$ bzw. $U_{ref}2$), was die Ausgabe eines zu Umschaltzwecken z.B. auf ein Notstromaggregat verwendbares Signal bewirkt.

## FIG 1

EP 0 338 489 A2

## Netzüberwachungsschaltung

Die Erfindung betrifft eine Schaltungsanordnung zur Netzüberwachung mit den im Oberbegriff des Hauptanspruchs angegebenen Merkmalen.

Für Netzüberwachungszwecke ist beispielsweise eine Schaltungsanordnung bekannt, die einen mit einem Widerstand belasteten Kondensator aufweist. Der Kondensator wird mit der gleichgerichteten Netzspannung, bzw. einem Teil davon, geladen. An den Kondensator ist ein Spannungsvergleicher angeschlossen, der mit einer Referenzspannungsquelle verbunden ist. Fällt die Netzspannung aus, sinkt die Kondensatorspannung ab. Erreicht oder sinkt sie unter den von der Referenzspannungsquelle vorgegebenen Wert, gibt der Spannungsvergleicher ein Signal ab. Das Signal kann zum Umschalten von der Netzspannung auf ein Notstromaggregat verwendet werden.

Ein wesentlicher Nachteil dieser Schaltungsanordnung ist, daß sie nur auf ein Ausfallkriterium eingestellt werden kann. Ein Ausfall der Netzspannung kann aber auf verschiedene Weisen verursacht sein. Die Netzspannung gilt als ausgefallen, wenn sie einen erlaubten Spannungswert unterschreitet oder wenn über einen erlaubten Zeitpunkt hinaus keine Netzspannung vorhanden ist. Je nachdem, auf welches Ausfallkriterium die Schaltungsanordnung reagieren soll, wird die Entladekurve des Kondensators durch entsprechende Wahl eines Lastwiderstandes entweder flacher oder steiler eingestellt.

Aufgabe der Erfindung ist es, eine Netzüberwachungsschaltung anzugeben, die gleichzeitig beide Ausfallkriterien, nämlich Netzunterspannung und Netzausfall über einen erlaubten Zeitpunkt hinaus, berücksichtigt. Dabei soll der Schaltungsaufbau möglichst einfach sein.

Diese Aufgabe wird erfindungsgemäß durch die im Kennzeichen des Anspruchs 1 angegebenen Merkmale gelöst. Danach weist die Netzüberwachungsschaltung zwei unabhängig voneinander arbeitende Teilschaltungen auf, von denen die eine für Netzunterspannungsund die andere für Netzausfälle über einen erlaubten Zeitpunkt hinaus zuständig ist. Über eine ODER-Schaltung lassen sich die Ausgangssignale der jeweiligen Teilschaltungen zu einem Signal zusammenfassen, das für Umschaltzwecke auf ein Notstromaggregat verwendet werden kann.

Werden die einzelnen Kondensatoren nicht mit einfachen Widerständen sondern jeweils mit einer Konstantstromquelle bzw. -senke belastet, wird das Entladeverhalten der in der Überwachungsschaltung vorhandenen Kondensatoren dem Entladeverhalten der Eingangskondensatoren des Netzteiles eines an das Netz angeschlossenen Gerätes angepaßt. Für deren schaltungstechnischen Aufbau werden nur einfache technische Mittel benötigt.

Die Netzüberwachungsschaltung basiert auf der Überlegung, daß die Netzteile der an das Netz angeschlossenen Geräte Eingangskondensatoren aufweisen, die bei Netzausfall eine oder mehrere Netzhalbwellen überbrücken. Wird das Netzteil durch das daran angeschlossene Gerät mit konstanter Leistung belastet, werden die Eingangskondensatoren bei Netzausfall mit konstanter Leistung entladen, bis es wegen Unterspannung abschaltet. Die Kondensatorspannung ändert dabei ihren Wert nach der Beziehung:

$$U_k = SQR(U_k^2(t=0) - 2 \bullet P \bullet t/C)$$

Dabei bedeuten:

$U_k$ - Kondensatorspannung

$U_k(t=0)$ - Kondensatorspannung zum Zeitpunkt $t=0$

$P$ - Entladeleistung

$C$ - Kapazität der Eingangskondensatoren

$t$ - Zeit

Die Beziehung stellt eine Wurzelfunktion dar. Messungen an den Eingangskondensatoren und grafische Betrachtung der Funktion zeigen, daß es sich im interessierenden Bereich durch eine Gerade annähern läßt. Sie weist eine Spannungssteilheit $dU/dt$ auf, die von der Entladeleistung $P$ und von der Kapazität $C$ der Eingangskondensatoren des Netzteils abhängt.

Da die Entladeleistung $P$ der z.B. an ein Netzteil gleicher Bauart angeschlossenen Geräte unterschiedlich ist, wird nicht die durch das gerade angeschlossene Gerät verursachte spezielle Entladekurve der Eingangskondensatoren des Netzteils, sondern eine dem Netzteil zugrundeliegende obere und untere Entladekurve nachgebildet, zwischen denen die speziellen Entladekurven liegen können. Dabei legt die obere Entladekurve einen Unterspannungsgrenzwert und die untere Entladekurve einen zeitlichen Grenzwert für länger anhaltende Netzausfälle fest. Auf diese Weise wird eine sichere Reaktion auf Netzausfälle aller Art und zu jedem Zeitpunkt gewährleistet.

Vorteilhafte Ausgestaltungen der Erfindung sind Gegenstand von Unteransprüchen.

Ein Ausführungsbeispiel der Erfindung ist anhand der Zeichnung näher erläutert.

Es zeigen:

FIG 1 eine Netzüberwachungsschaltung gemäß der Erfindung und

FIG 2 die der Netzüberwachungsschaltung nach FIG 1 zugrundeliegenden Spannungsverläufe für Netzunterspannungs- und Netzausfallerkennung.

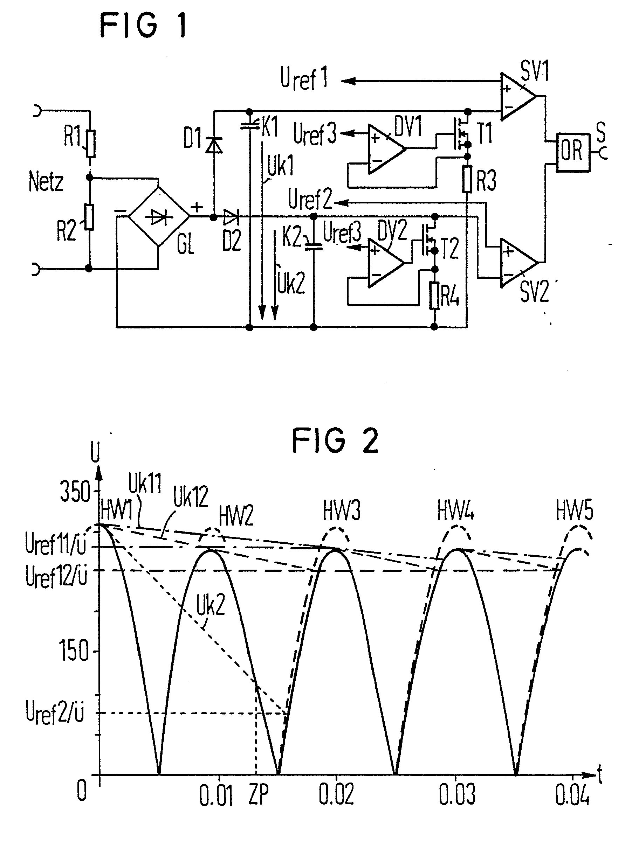

FIG 1 zeigt die Netzüberwachungsschaltung gemäß der Erfindung. Die Netzspannung wird wegen der besseren Auswertbarkeit durch die Widerstände R1 und R2 um den Faktor

$$\ddot{u} = R2/(R1 + R2)$$

heruntergeteilt. Anschließend wird die heruntergeteilte Netzspannung von dem Gleichrichter GL gleichgerichtet. An den Gleichrichter GL sind über jeweils eine Diode D1 bzw. D2 je ein Kondensator K1 bzw. K2 angeschlossen. Die Dioden D1 und D2 entkoppeln die Kondensatoren K1 und K2 voneinander. Die Kondensatoren K1 und K2 werden mit der gleichgerichteten Spannung geladen. An jeden Kondensator ist parallel eine Konstantstromquelle bzw. -senke angeschlossen, die sie gleichmäßig belasten. Die jeweiligen Kondensatorspannungen sind je einem Spannungsvergleicher SV1 bzw. SV2 zugeführt. Jeder der Spannungsvergleicher SV1 bzw. SV2 liegt an einer eigenen Referenzspannungsquelle $U_{ref}1$ bzw. $U_{ref}2$. Die Ausgänge der Spannungsvergleicher werden über die ODER-Schaltung OR geführt und miteinander zu dem Ausgangssignal S verknüpft.

Die Konstantstromquellen bzw. -senken bestehen jeweils aus einer aus einem Schalttransistor T1 bzw. T2 und einem Widerstand R3 bzw. R4 gebildeten Reihenschaltung, deren jeweilige Verbindungsstelle zwischen Schalttransistor und Widerstand jeweils an den negativen Eingang eines Differenzverstärkers DV1 bzw. DV2 angeschlossen ist. Die positiven Eingänge des Differenzverstärkers DV1 und DV2 sind an eine dritte Referenzspannungsquelle $U_{ref}3$ angeschlossen. Ferner sind die Ausgänge der beiden Differenzverstärker DV1 und DV2 mit dem jeweiligen Steuereingang desjenigen Schalttransistors verbunden, der schon über den negierten Eingang mit dem betreffenden Differenzverstärker in Verbindung steht.

Die Konstantstromquellen bzw. -senken entladen die Kondensatoren linear, wenn die Netzspannung ausfällt. Der Entladestrom für den ersten Kondensator K1 wird durch die dritte Referenzspannung $U_{ref}3$ und den Widerstand R3, für den zweiten Kondensator K2 durch die dritte Referenzspannung $U_{ref}3$ und den Widerstand R4 bestimmt. Unterschreitet die Kondensatorspannung des ersten Kondensators K1 die erste Referenzspannung $U_{ref}1$ bzw. unterschreitet die Kondensatorspannung des zweiten Kondensators K2 die zweite Referenzspannung $U_{ref}2$, kippt die Ausgangs spannung des ersten Spannungsvergleichers SV1 bzw. des zweiten Spannungsvergleichers SV2 vom logischen Spannungspegel L zum logischen Spannungspegel H. Beim Wechsel des Spannungspegels wenigstens einer der Ausgangsspannungen der Spannungsvergleicher SV1 bzw. SV2 wird am Ausgang S ein entsprechendes Signal erzeugt.

Die Einstellung der Entladeströme ist aus FIG 2 ersichtlich. Dargestellt sind fünf Halbwellen HW1 bis HW5 der gleichgerichteten Netzspannung. Angenommen wird, daß ab einer Netzspannung von 200 Veff eine Unterspannung vorliegt. Weiter wird angenommen, daß ein Netzausfall von der Dauer einer Netzhalbwelle von den Eingangskondensatoren des Netzteils des angeschlossenen Gerätes überbrückt wird. Dargestellt ist der extreme Fall, daß ausgehend von der den Sollwert aufweisenden ersten Halbwelle HW1 ab der zweiten Halbwelle HW2 nur noch Halbwellen mit dem Unterspannungsgrenzwert auftreten.

Die Einstellung der ersten Entladekurve Uk1, die zur Erkennung von Netzunterspannungen dient, ist einschließlich der Grenzen innerhalb des durch die aufgespaltenen Entladekurven Uk11 und Uk12 festgelegten Bereichs möglich. Die obere Grenze ist dabei durch den Scheitelpunkt der ersten Halbwelle HW1 und der dritten Halbwelle HW3, und die untere Grenze ist durch den Scheitelpunkt der ersten Halbwelle HW1 und der zweiten Halbwelle HW2 festgelegt. Ein erstes Maß für die Wahl der Referenzspannung $U_{ref}1$ ist durch den Schnittpunkt der jeweiligen ersten Entladekurve Uk1 mit der dritten Halbwelle HW3 gegeben, dem jeweils ein Spannungswert zugeordnet ist. Zum Erhalt der dem Ausführungsbeispiel zugrundeliegenden ersten Referenzspannung $U_{ref}1$ ist dieser Spannungswert noch durch den Faktor 1/ü zu multiplizieren.

In der Praxis sind zwischen dem fehlerfreien und dem in FIG 2 dargestellten Fall die verschiedensten Unterfälle denkbar. So sind z.B. Fälle denkbar, in denen die zweite Halbwelle HW2 einen gerade noch erlaubten Spannungswert, die dritte Halbwelle HW3 einen Unterspannungswert und die vierte Halbwelle HW4 wieder einen erlaubten Spannungswert aufweist. Die zweite Halbwelle HW2 lädt den Kondensator K1 nur leicht nach, wodurch die Entladekurve Uk1 nur geringfügig nach oben parallel verschoben wird. Der Schnittpunkt der Entladekurve Uk1 mit der durch die Referenzspannung $U_{ref}1$ festgelegten Waagrechten wandert nach links. Es ergibt sich deshalb eine vorzeitige Reaktion der Überwachungsschaltung, da die vierte Halbwelle HW4 wieder einen erlaubten Spannungswert aufweist und eine Reaktion deshalb noch nicht nötig wäre. Die Überwachungsschaltung reagiert in diesem Fall sehr empfindlich.

Die Empfindlichkeit kann dadurch gesenkt werden, daß die erste Referenzspannung $U_{ref}1$ innerhalb der durch die Referenzspannungen $U_{ref}11$ und $U_{ref}12$ vorgegebenen Grenzen kleiner gewählt wird, als es dem Schnittpunkt der ersten Entladekurve Uk1 mit der dritten Halbwelle HW3 zukommt. In diesem Zusammenhang sind jedoch Fälle denkbar, bei denen die Überwachungsschaltung erst nach mehr als einer jeweils eine Unterspannung aufweisenden Halbwelle reagiert. Oft sind aber die jeweils angeschlossenen Geräte gegen derartige kurzzeitige Unterspannungen unempfindlich. In der Praxis hat sich deshalb folgendes Vorgehen bei der Schaltungseinstellung für Unterspannungserkennung bewährt: Ausgehend von einer zwischen der Entladekurven Uk11 und Uk12 liegenden ersten Entladekurve Uk1 wird die Netzspannung bis auf den für das angeschlossene Gerät gerade noch erlaubten Spannungspegel heruntergeregelt und dann die erste Referenzspannung U$_{ref}$1 so eingestellt, daß die Überwachungsschaltung gerade noch nicht reagiert.

Die Einstellung der zweiten Entladekurve Uk2, die zur Erkennung von Netzausfällen, die länger als eine vorgegebene Zeitdauer sind, dient, hängt von dem Zeitpunkt ZP innerhalb der zweiten Hälfte, der z.B. zweiten Halbwelle HW2 ab. Für das Ausführungsbeispiel ist angenommen, daß Netzausfälle größer 8ms angezeigt werden sollen. Da eine Netzhalbwelle 10ms dauert, bleibt noch genügend Zeit, um im Störfall auf das Notstromaggregat umzuschalten. Der Zeitpunkt ZP wird deshalb ausgehend von dem Startpunkt der zweiten Halbwelle HW2 auf der Zeitachse auf einen Zeitpunkt ZP = 8ms gelegt. Der Schnittpunkt der den Sollwert aufweisenden zweiten Halbwelle HW2 mit der durch den Zeitpunkt ZP gelegten Senkrechten bestimmt ausgehend von dem Scheitelpunkt der den Sollwert aufweisenden ersten Halbwelle HW1 das Gefälle der zweiten Entladekurve Uk2. Die zweite Referenzspannung U$_{ref}$2 ist dann geringfügig größer einzustellen, als der dem Schnittpunkt der zweiten Entladekurve Uk2 mit der den Sollwert aufweisenden dritten Halbwelle HW3 zugeordnete Spannungswert, wobei bezogen auf das Ausführungsbeispiel noch der Faktor 1/Ü zu berücksichtigen ist.

**Ansprüche**

1. Schaltungsanordnung zur Netzüberwachung unter Verwendung eines mit einem Widerstand gemäß einer entweder zur Unterspannungs- oder zur Netzausfallserkennung dienenden Entladekurve belasteten Kondensators, der an die Ausgangsklemmen einer wenigstens mit Teilen der Netzspannung gespeisten Gleichrichterschaltung angeschlossen und mit einem Eingang eines an einer Referenzspannung anliegenden Spannungsvergleichers verbunden ist, **dadurch gekennzeichnet,** daß ein erster Kondensator (K1) vorgesehen ist, der mit einem so gewählten ersten Widerstand belastet ist, daß seine zur Unterspannungserkennung dienende erste Entladekurve (Uk1) mindestens (Uk11) ein durch die Scheitelpunkte einer den Sollwert aufweisenden ersten (HW1) und den Grenzwert für Unterspannungserkennung aufweisenden dritten (HW3), und höchstens (Uk12) ein durch die Scheitelpunkte der ersten (HW1) und der Grenzwert für Unterspannungserkennung aufweisenden zweiten (HW2) Halbwelle festgelegtes Gefälle aufweist, daß der erste Kondensator (K1) mit einem ersten Spannungsvergleicher (SV1) verbunden ist, an den eine erste Referenzspannung (U$_{ref}$1) angelegt ist, deren Spannungswert entweder gemäß dem im Schnittpunkt der ersten Entladekurve (Uk1) mit der ansteigenden Flanke der den Grenzwert für Unterspannungserkennung aufweisenden dritten Halbwelle (HW3) auftretenden Spannungswert oder, ohne den im Schnittpunkt dieser Halbwelle mit der das höchste Gefälle aufweisenden ersten Entladekurve (Uk12) auftretenden Spannungswert zu unterschreiten, kleiner gewählt ist, daß ein ebenfalls an die gleichgerichtete Spannung angeschlossener zweiter Kondensator (K2) vorgesehen ist, der mit einem so gewählten zweiten Widerstand belastet ist, daß seine zur Netzausfallserkennung dienende zweite Entladekurve (Uk2) ein Gefälle aufweist, das durch den Scheitelpunkt einer den Sollwert aufweisenden ersten Halbwelle (HW1) und dem von der den Sollwert aufweisenden zweiten Halbwelle (HW2) und einem innerhalb der zweiten Hälfte des Zeitbereichs der zweiten Halb welle (HW2) vorgegebenen Zeitpunkt gebildeten Schnittpunkt festgelegt ist, daß der zweite Kondensator (K2) mit einem zweiten Spannungsvergleicher (SV2) verbunden ist, an den eine zweite Referenzspannung (U$_{ref}$2) angelegt ist, deren Spannungswert geringfügig größer als der im Schnittpunkt der zweiten Entladekurve (Uk2) mit der ansteigenden Flanke der den Sollwert aufweisenden dritten Halbwelle (HW3) auftretende Spannungswert gewählt ist, daß zwischen Gleichrichterschaltung (GL) und je einem der beiden Kondensatoren (K1 bzw. K2) je eine Diode (D1 bzw. D2) geschaltet ist und daß die Ausgänge der beiden Spannungsvergleicher (SV1 bzw. SV2) über eine ODER-Schaltung (OR) miteinander verknüpft sind.

2. Schaltungsanordnung nach Anspruch 1, **dadurch gekennzeichnet,** daß der erste und zweite Kondensator (K1 und K2) jeweils mit einer Konstantstromquelle bzw. -senke belastet ist.

3. Schaltungsanordnung nach Anspruch 2, **dadurch gekennzeichnet,** daß die jeweilige Konstantstromquelle bzw. -senke aus einer aus einem Schalttransistor (T1 bzw. T2) und einem Widerstand (R3 bzw. R4) bestehenden Reihenschaltung gebildet ist, deren Verbindungsstelle zwischen Schalttransistor (T1 bzw. T2) und Widerstand (R3 bzw. R4) mit dem negativen Eingang eines mit dem positiven Eingang an einer weiteren Referenzspannungsquelle (U$_{ref}$3) anliegenden Differenzverstärkers (DV1 bzw. DV2) verbunden ist, dessen Ausgang an den Steuereingang des Schalttransistors (T1 bzw. T2) angeschlossen ist.

4. Schaltungsanordnung nach Anspruch 3, **dadurch gekennzeichnet,** daß die Differenzverstärker (DV1 und DV2) jeweils an die gleiche weitere Referenzspannungsquelle ($U_{ref}3$) angeschlossen sind.

EP 0 338 489 A2

# FIG 1

# FIG 2